# EUROPEAN PATENT SPECIFICATION

(11) **EP 3 994 777 B1**
(45) Date of publication and mention of the grant of the patent: **06.03.2024**
(21) Application number: 20835019.9
(22) Date of filing: 01.07.2020
(51) Int. Cl.: H01S 5/40, H01S 5/022, H01S 5/02, G02B 6/42

(54) **LASER ENGINE SUPPORTING MULTIPLE LASER SOURCES**
LASERMOTOR MIT UNTERSTÜTZUNG MEHRERER LASERQUELLEN
MOTEUR LASER SUPPORTANT DE MULTIPLES SOURCES LASER

(30) Priority: 02.07.2019 US 201962869605 P
(43) Date of publication of application: 11.05.2022
(73) Proprietor: Aayuna Inc., Allentown, Pennsylvania 18106 (US)
(72) Inventor: SHASTRI, Kalpendu, Orefield, Pennsylvania 18069 (US); SHASTRI, Anujit, San Franscisco, California 94105 (US); PATHAK, Soham, Allentown, Pennsylvania 18106 (US); DAMA, Bipin D., Bridgewater, New Jersey 08807 (US); LEONHARTSBERGER, Alan, Kempton, Pennsylvania 19529 (US); DAVE, Rutvij, Allentown, Pennsylvania 18103 (US); YELAMARTY, Rao, Allentown, 18103 (US)
(74) Representative: terpatent Patentanwälte und European Patent Attorneys ter Smitten Eberlein -Van Hoof
(86) International application number: PCT/US2020/040562
(87) International publication number: WO 2021/003306

(56) References cited:
- EP-A1- 0 642 045
- JP-A- H0 786 693
- KR-A- 20030 073 209
- US-A- 5 659 566
- US-A1- 2003 072 343
- US-A1- 2015 370 015
- US-A1- 2016 246 004

## Description

### Technical Field

The present invention relates to assemblies for optical communication systems and, more particularly, to a configuration that utilizes a common optical reference substrate to provide coupling between a fiber array and an array of discrete laser diode devices.

### Background of the Invention

There is an ever-increasing need to reduce the size of optical transmission systems for a variety of applications, ranging from communications to computing. A pressure in response to the size reduction requirement is the need to increase the data transmission capacity (bandwidth) of many systems (such as a data center, for example). In order to provide the increased transmission capacity, the number of laser sources incorporated within a given sub-system needs to increase as well. While various approaches have been put forward to reduce the overall footprint of laser modules, the need to include a plurality of sources within a module while maintaining low cost and complexity remains problematic.

EP 0 642 045 discloses mounting and coupling on a silicon substrate an array of fibers to an array of semiconductor lasers via an array of lenses, the fibers being inserted in V-grooves, the semiconductor lasers being mounted on a further intermediate silicon substrate.

### Summary of the Invention

The needs remaining in the prior art are addressed by the present invention, which relates to assemblies for optical communication systems and, more particularly, to a configuration that utilizes a common optical reference substrate to provide coupling between a fiber array and an array of discrete laser diode devices. For the purposes of the present invention, the assembly may be referred to at times as a "laser engine", which is intended to refer to the assembled coupling of an array of optical fibers to a set of laser diode sources.

In accordance with the principles of the present invention, an optical reference substrate is utilized as a common platform upon which both a fiber array and a laser diode array are disposed and positioned such that alignment between the components is straightforward and efficient. A top surface of the optical reference substrate is patterned to include alignment fiducials and bond locations for both the fiber array and the laser diode array. A receiving block element of the fiber array may be formed to contain alignment fiducials that mate with the optical reference substrate fiducials and, similarly, a silicon submount for the laser diode array may be configured to contain alignment fiducials that mate with a separate set of alignment fiducials formed on the optical reference substrate. Inscribed/etched bond outlines formed on the optical reference substrate may also be used to define the proper locations for both the receiving block element and the silicon submount. The receiving block is configured to present the optical fibers at an elevation that allows for straightforward optical alignment with the output beams from the laser diodes positioned on the silicon submount. By virtue of using a common optical reference substrate to support both the receiving block and the silicon submount, the ability to achieve and maintain optical alignment between the fibers and the laser diodes is provided in an efficient and economical compact configuration.

Other passive optical devices (e.g., isolators, lenses, filters, and the like) are also disposed at defined locations on the optical reference substrate, with other fiducials/bond lines formed to delineate the specific locations for placement of these passive devices. It is an aspect of the present invention that the positioning of these passive optical devices on the reference substrate (as opposed to on the silicon submount, as found in many prior art arrangements) simplifies the fabrication and expense of the laser diode source component without compromising the optical alignment created by the passive devices between the laser diode and optical fiber.

In various embodiments of the present invention, the optical reference substrate may comprise a silicon substrate that is patterned and etched using well-known techniques to create the patterned surface used to properly place and align the receiving block and silicon submount. In other embodiments, the optical reference substrate may comprise a glass substrate that is similarly processed (perhaps using a machining technique) to create the necessary surface features used for alignment and bonding. Inasmuch as glass does not conduct heat as well as silicon, an opening may be formed through the glass substrate in the location where the laser diode array is located, with an additional heat sink component (for example, a highly conductive metal slug) disposed at this location to direct the thermal energy created by the laser diodes away from the assembly. Alternatively, a thermo-electric cooler (TEC) may be disposed in combination with the metal slug to "cool" the laser diodes in a well-known manner that maintains operating conditions for the laser devices (where in a preferred arrangement, a non-hermetic TEC may be used). In each case, the use of a low thermal conductivity optical reference substrate ensures that the other components disposed directly on the substrate (i.e., lenses, filters, receiving block) are not affected by the temperature changes at the laser diodes and continue to operate in the nominal ambient of the assembly.

It is to be understood that besides glass, any other material exhibiting a low thermal conductivity and a coefficient of thermal expansion (CTE) similar to silicon may be used as the optical reference substrate in the arrangement of the present invention.

An exemplary embodiment of the present invention takes the form of a laser source assembly based upon the use of a common optical reference substrate, with the top major surface of the common optical reference substrate defining an optical reference plane. A receiving block (used for supporting an array of optical fibers) is attached to the top major surface of the common optical reference substrate at a first defined location, where the receiving block is formed to include a plurality of V-grooves configured to support the array of optical fibers. A silicon submount is also attached to the top major surface of the common optical reference substrate, in this case at a second defined location spaced apart from the first defined location (supporting the fiber receiving block). The silicon submount is used to support an array of laser diode sources in optical alignment with the plurality of optical fibers supported by the receiving block in a one-to-one association. In most cases, the laser source assembly will also include a plurality of passive optical devices positioned on the common optical reference substrate between the receiving block and the silicon substrate, the positions of the lenses adjusted to achieve optical alignment between the plurality of laser diode sources and the plurality of optical fibers.

Other and further embodiments of the present invention may become apparent during the course of the following discussion and by reference to the accompanying drawings.

### Brief Description of the Drawings

Referring now to the drawings, where like numerals represent like parts in several views:
FIG. 1 is an isometric view of an exemplary laser assembly, including an array of laser diodes and an associated array of optical fibers, positioned in optical alignment on a common optical reference substrate;
FIG. 2 is a cut-away side view of the assembly of FIG. 1, taken along line 2-2;
FIG. 3 is a simplified view of the arrangement of FIG. 2, illustrating in particular the elements associated with providing optical alignment in accordance with the teachings of the present invention;
FIG. 4 is an isometric view of an exemplary receiving block, used to position a fiber array component along the optical axis defined by the common optical reference substrate;
FIG. 5 is an isometric view of a fiber support substrate component of the fiber array configuration, illustrating the two different sizes of V-grooves formed along the substrate (for supporting stripped fiber ends along a narrow V-groove section and cladded fiber lengths along a wider V-groove section);
FIG. 6 is an isometric view of the fiber array configuration, illustrating the position of the cover plate over the substrate of FIG. 5, the cover plate used to mate with the receiving block and define the positions of the optical fiber endfaces along the optical axis;
FIG. 7 is an isometric view of an exemplary laser diode subassembly, including a silicon submount element that is positioned on the common optical reference substrate;
FIG. 8 illustrates an enlarged portion of the laser diode subassembly and associated passive optical devices, all positioned on the common optical reference substrate;
FIG. 9 is an isometric view of an exemplary common optical reference substrate, in this case comprising a silicon material that is patterned and etched to form regions for bonding the fiber array receiving block, laser diode array submount, and all passive optical devices, the patterned locations assisting in providing optical alignment between the laser diode array and the optical fiber array;
FIG. 10 is an isometric view of an alternative common optical reference substrate, in this case comprising a glass (or other low thermal conductivity) material and including a large aperture in the area where the laser diode submount is positioned, the aperture used to provide a path for heat transfer away from the laser diode array;
FIG. 11 is a view from the underside of the low thermal conductivity common substrate of FIG. 10, showing the position of an exemplary laser diode array silicon submount over the large heat transfer aperture;
FIG. 12 is an isometric view of an exemplary laser engine based upon a low thermal conductivity optical reference substrate as disposed on a carrier assembly element (such as a printed circuit board);
FIG. 13 is a side view of the assembly of FIG. 12, illustrating the position of an opening formed in the PCB below the heat transfer aperture of the common optical reference substrate, as well as a set of thermal transport components used to efficiently modify the ambient temperature at the laser diode array;
FIG. 14 is an enlargement of a portion of FIG. 13, clearly showing the individual elements used to form the set of thermal transport components;
FIG. 15 contains an isometric view of an exemplary embodiment of the present invention, formed to include a lid component that also directly attaches to the common optical reference substrate and provides protection to the free space optical path between the array of laser diodes and the array of optical fibers;
FIG. 16 is an isometric view of a complete laser engine of the present invention, illustrating the positioning of the lid component to cover portions of both the fiber array configuration and the laser diode array source; and
FIG. 17 is a cut-away view of the complete laser engine of FIG. 16.

### Detailed Description

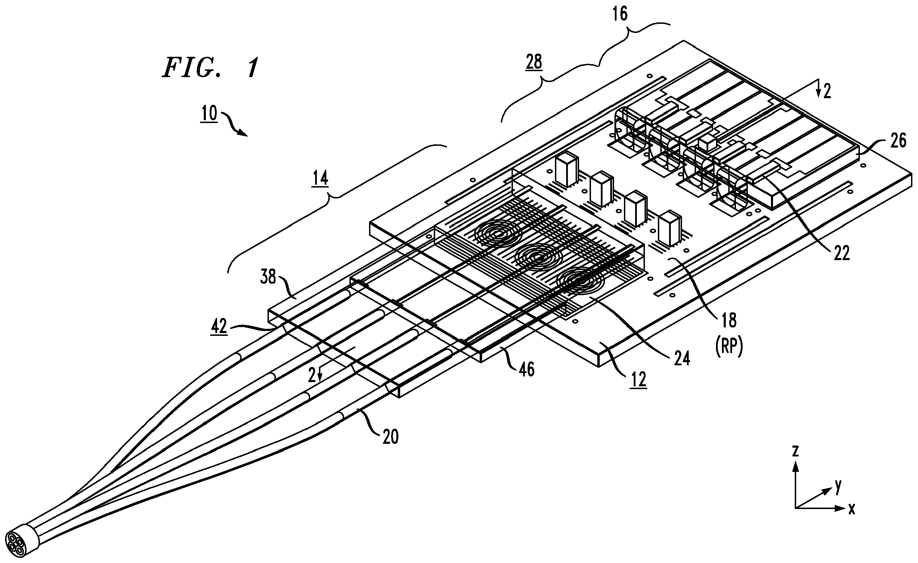

FIG. 1 is an isometric view of an exemplary laser assembly, including an array of laser diodes and an associated array of optical fibers, positioned in optical alignment on a common optical reference substrate. Throughout the remainder of this description the "laser assembly" will be referred to as a "laser engine", with the understanding that such an engine consists of a self-contained source of multiple laser beams which are thereafter directed into an associated array of optical fibers.

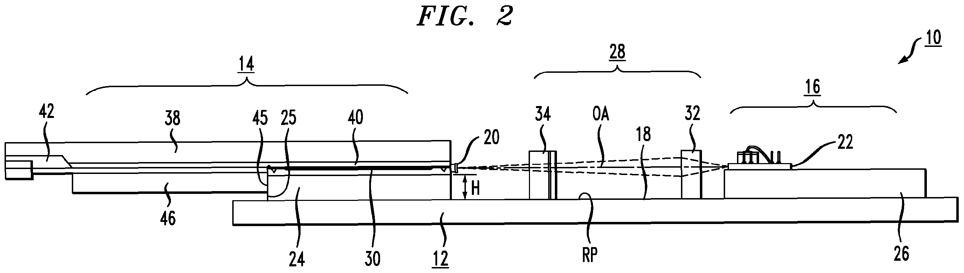

In particular, an exemplary laser engine 10 is formed in accordance with the principles of the present invention to utilize a common optical reference substrate to support the fiber-related elements of the laser engine in optical alignment with the laser diode-related elements of the same laser engine. As shown in FIG. 1, a common optical reference substrate 12 is used to support a fiber array configuration 14 in optical alignment with a laser diode array source 16. FIG. 2 is a cut-away side view of laser engine 10, taken along line 2-2 of FIG. 1. It is an aspect of the present invention that optical reference substrate 12 is formed of a material that exhibits a top reference surface 18 with a degree of flatness sufficient to be used as a defined "reference plane" RP for laser engine 10 (reference plane RP is shown in FIGs. 1 and 2 as the xy plane for the defined three-axis Cartesian system).

The particular embodiment illustrated in FIGs. 1 and 2 shows an array of four optical fibers 20 as supported within fiber array configuration 14, with an associated array of four semiconductor laser diodes 22 included as part of laser diode array source 16. It is to be understood that the use of a set of four fiber/laser diode couplings is exemplary only; indeed, a laser engine formed in accordance with the present invention may be used to provide coupling between only a single optical fiber and a single laser diode or, conversely, between a larger array of optical fibers (for example, a "ribbon" of twelve fibers) and associated laser diodes. In many exemplary embodiments of the present invention, the array of optical fibers 20 may comprise polarization-maintaining (PM) optical fiber, which is often the preferred type of fiber for providing a transmission path from laser diodes. However, it is to be understood that the scope of the present invention is not limited to any particularly type of fiber, as along a fiber array configuration 14 is created in a manner that the spacing (pitch) between adjacent fibers is aligned with the set of free-space optical beams emitted from laser diodes 22.

In accordance with the principles of the present invention, both fiber array configuration 14 and laser diode array source 16 include support elements that are attached to top reference surface 18 of optical reference substrate 12. By controlling the dimensions of these support elements, the defined reference plane RP of top surface 18 may be translated upward to define the optical axis OA created between fibers 20 and laser diodes 22. As best shown in FIG. 2, fiber array configuration 14 is formed to include a receiving block 24 that is attached to top surface 18 of optical reference substrate 12 at a first predetermined location. Laser diode array source 16 includes a silicon submount 26 that is also attached to top surface 18 of optical reference substrate 12, as shown in FIGs. 1 and 2. Thus, by knowing and controlling the physical dimensions of receiving block 24 and silicon submount 26, the disposition of these elements on a common reference plane functions to expedite the process steps involved in creating optical alignment between fibers 20 and laser diodes 22.

Also depicted in FIGs. 1 and 2 is a set of passive optical devices 28 (e.g., lenses 32 and isolators 34) that are typically included in a laser engine to improve its performance (e.g., in terms of minimizing reflections, improving coupling efficiency, and the like). In contrast to typical prior art configurations that include these passive optical components within the laser subassembly, laser engine 10 of the present invention is configured to dispose the passive optic components directly on reference top surface 18 of optical reference substrate 12.

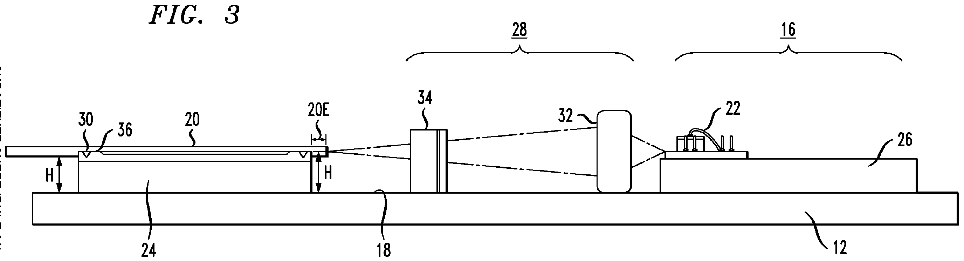

FIG. 3 is a simplified version of the side view of FIG. 2, where in this case most of the elements of fiber array configuration 14 have been removed in order to clearly illustrate the placement and dimensions of receiving block 24 and silicon submount 26 on optical reference substrate 12. An exemplary optical fiber 20 is shown as positioned within a V-groove 30 formed within receiving block 24, where V-groove 30 prevents the lateral motion of fiber 20, further ensuring continued alignment between the beam emitted from laser diode 22 and associated optical fiber 20. In the view of FIG. 3, passive optics 28 is shown as including lens 32 disposed beyond the output from laser diode 22, with optical isolator 34 positioned between lens 32 and an endface 20E of optical fiber 20. The optical axis OA defined by emission from the combination of laser diodes 22 and their associated lenses 24 is used to define the proper dimensions of receiving block 24 so that the core region of optical fiber 20 will also be disposed along optical axis OA.

As mentioned above, the height H of receiving block 24 is designed to facilitate the process of creating optical alignment between fiber 20 and the output beam propagating along optical axis OA. In particular, alignment with core region 21 of fiber 20 is required to maximize the coupling efficiency between the laser diodes and optical fibers. Inasmuch as the diameter of optical fiber 20, as well as core region 21, are known parameters, the combination of the depth of V-groove 30 and the height H of receiving block 24 are controlled to achieve this result. Said another way, it is an aspect of the present invention that by using top surface 18 of optical reference substrate 12 as a reference plane for all components, it is possible to properly configure the plurality of V-grooves 30 formed in receiving block 24 to improve the efficiency of the process used to provide alignment of optical fibers 20 with optical axis OA of laser engine 10.

As shown in FIGs. 2 and 3, an end portion 20E of illustrated fiber 20 extends beyond an endface 24E of receiving block 24, as well as beyond the remaining elements forming fiber array configuration 14. It has been found that the slight protrusion of fiber 20 beyond the endface of fiber array configuration 14 prevents the epoxy bead (used to attach the fibers to the array unit) from wicking upward and covering (in whole or in part) fiber endface 20E. Indeed, as will be discussed below, fiber array configuration 14 is particularly formed to define the axial separation between fiber endface 20E and laser diode 22 (i.e., along the Z-axis direction of laser engine 10.

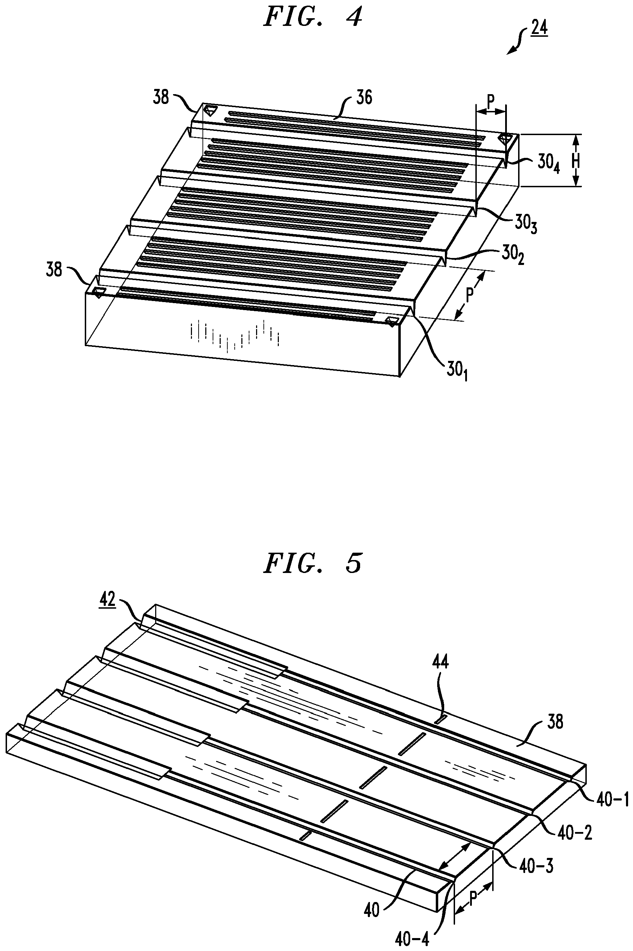

FIG. 4 is an isometric view of receiving block 24, showing a set of four V-grooves 30 (shown as V-grooves 30₁, 30₂, 30₃, 30₄) formed in parallel within a top surface 36 of receiving block 24. A pitch P between adjacent V-grooves 30 is shown. During the assembly of laser engine 10, the positioning of lenses 32 may be adjusted, if necessary, to ensure that the individual output beams are directed into the core regions of the supported fibers. In most cases, it is presumed that an array of polarization-maintaining fibers will be supported on receiving block 24.

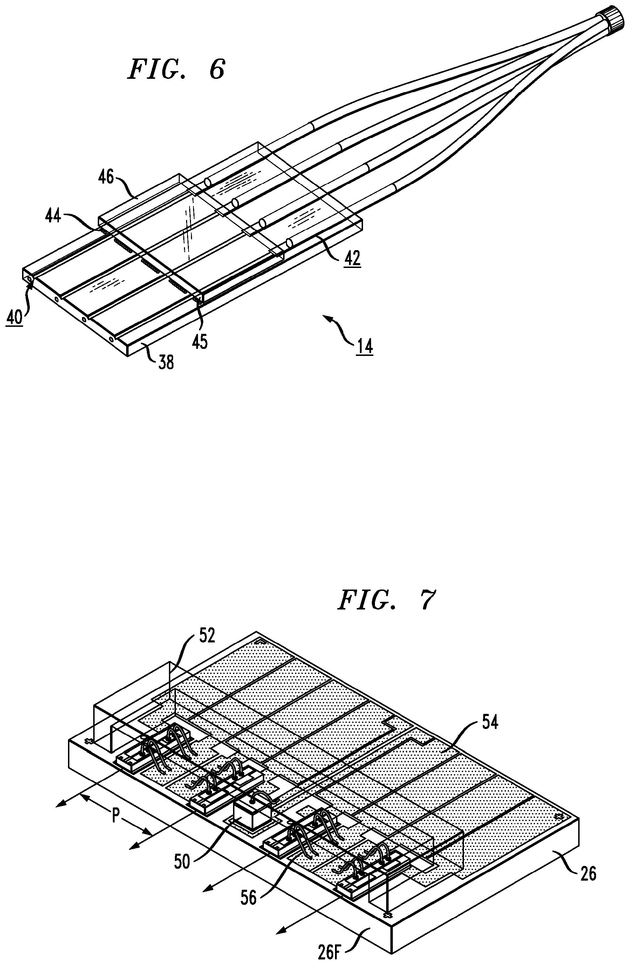

FIG. 5 illustrates an exemplary fiber support substrate 38, which is one component of fiber array configuration 14. Support substrate 38 is shown as including a first plurality of V-grooves 40 that are used to support the stripped end portions of fibers 20, where V-grooves 40 will align with receiving block V-grooves 30 when fiber array configuration 14 is mounted upside-down over receiving block 24 (as best shown in FIGs. 1 and 2). Also shown in FIG. 5 is a second plurality of V-grooves 42, aligned with first plurality of V-grooves 40 but having a larger depth and width to accommodate a cladded portion of fibers 20 as they are positioned along support substrate 38. Substrate 38 is further configured to include a set of vertical slots 44, used to define the placement of an associated cover plate 46, as shown in FIG. 6. In particular, FIG. 6 is an isometric view of fiber array configuration 14, showing the positioning of cover plate 46 with respect to substrate 38 and included fibers 20. Also depicted in this view is an endwall surface 45 of cover plate 46. Indeed, the location of vertical slots 44 is used to define the placement of endwall surface 45 of cover plate 46 such that endwall surface 45 will engage with receiving block 24 at the desired position when cover plate 46 is positioned to abut receiving block 24.

As mentioned above, the arrangement of fiber array configuration 14 is used to define the position of fiber array 20 with respect to optical reference substrate 12, which assists in the subsequent procedures used to achieve optical alignment between laser diodes 22 and fibers 20. Fiber array configuration 14 is particularly formed to allow for an "overhang" of fiber endface 20E to prevent epoxy or other bonding material associated with the mating of substrate 38 to receiving block 24 from covering the fiber. Fiber array configuration 14 is also used to define the optimum position of endface 20E of each fiber 20 such that maximum coupling between laser diodes 22 and fibers 20 is achieved. To that end, cover plate 46 is used to provide the desired Z-axis positioning of fibers 20 along the optical axis. Referring back to FIG. 2, it is clear that fiber array configuration 14 is disposed in position over receiving block 24 such that endwall surface 45 of cover plate 46 is brought into contact with an endwall surface 25 of receiving block 24. Using this physical "stop" for positioning fiber array configuration 14 thus ensures the desired separation between fibers 20 and laser diodes 22, in accordance with the teachings of the present invention. That is, fiber array configuration includes a mechanical stop that defines the proper axial placement of the fiber endfaces 20E within laser engine 10.

Turning now to laser diode array source 16, FIG. 7 is an isometric view of an exemplary silicon submount 26 used to support and energize a set of four semiconductor laser diodes 22, disposed as shown near a front sidewall 26F of silicon submount 26. Also shown in FIG. 7 is a thermistor 50, used to monitor the temperature of silicon submount 26 and a lid 52 disposed as shown. Thermistor 50 is preferably disposed as shown in the middle of the laser diode array.

A set of metal contact regions 54 is formed on the top surface of submount 26 and are connected to the individual laser diodes 22 by plurality of wirebonds 56. As is well known in the art, an external power source is connected to contact regions 54 and used to energize the individual laser diodes.

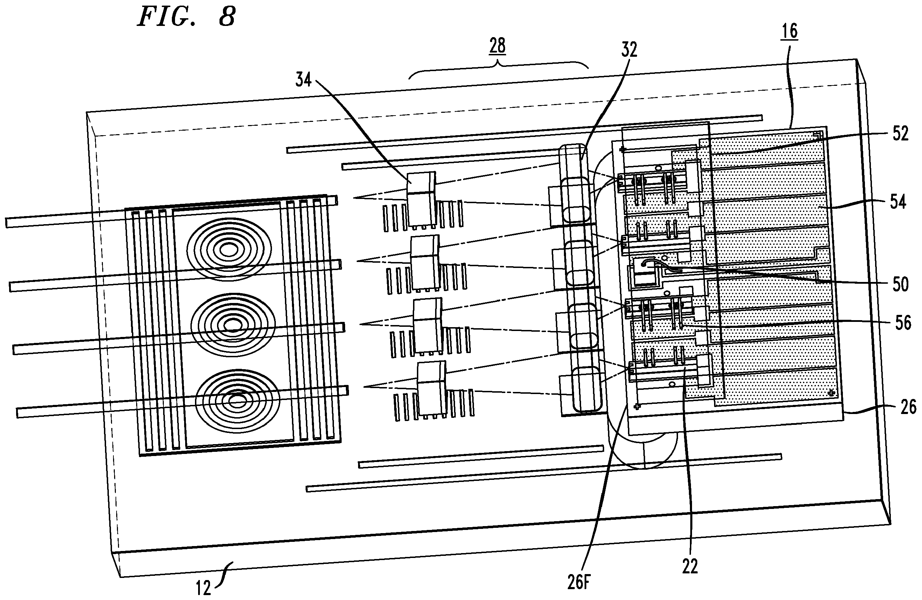

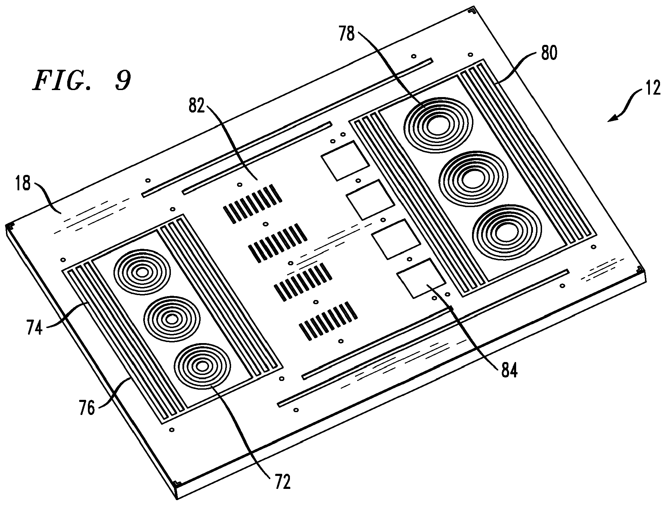

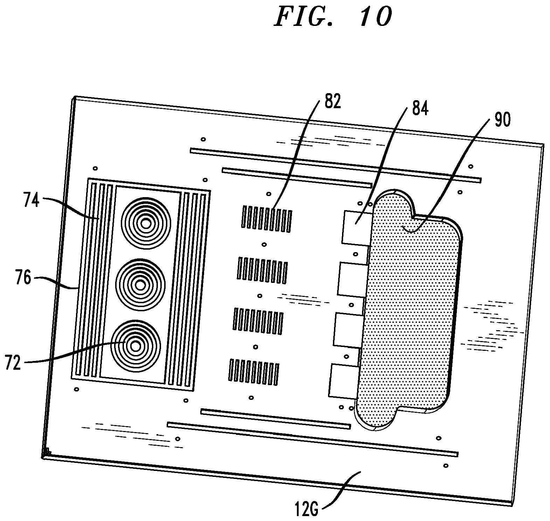

FIG. 8 illustrates laser diode array source 16 (as shown in FIG. 7), as well as passive optical devices 28, in position on common optical reference substrate 12. In this view, the beams generated by laser diodes 22 are shown as passing through an array of lenses 32, where the focused beams formed by lenses 32 thereafter pass through aligned isolators 34. As mentioned above and described in detail below in association with FIGs. 9 and 10, common optical reference substrate 12 is formed to include various alignment fiducials and bond locations on its top surface 18 that are used to designate the placement positions for silicon submount 26, lenses 32 and isolators 34 (as well as fiber array receiving block 24).

FIG. 9 is an isometric view of an exemplary common optical reference substrate 12, particularly showing the various features that are formed in top surface reference plane 18 and used to define the proper positioning and attachment of fiber array configuration 14 and laser diode source 16, as well as passive optical devices 28, so as to form laser engine 10 in accordance with the principles of the present invention.

In the prior art, various passive optical devices were positioned on silicon submount 26 with the array of laser diodes 22. While possible, it is believed that some of the processing steps used in the formation of the lens arrangement alignment features (e.g., etching steps) are not advisable to be performed in the vicinity of a laser diode electrode structure. The design configuration of the present invention, where passive optical devices 28 are instead disposed directly on optical reference substrate 12, now enables the use of any suitable process (e.g., etching of silicon or machining of glass) to form the lensing alignment features without any need to worry about the laser diode structures. For example, a deep RIE process may be used to form the individual alignment features on silicon-based optical reference substrate 12; this type of reactive ion etching process is not particularly well-suited for use in close proximity to a mounted laser structure.

Particularly illustrated in FIG. 9 is a first set of bond lines 72 that are formed in top surface 18 of reference substrate 12 and disposed at a location defined for the placement of receiving block 24. In most cases, an epoxy material is used to bond the components together. An epoxy dam 74 may be included with bond lines 72, as shown, to prevent any overflow of epoxy beyond the boundary of receiving block 24. In accordance with the present invention, receiving block 24 is properly positioned when placed to align with this bond line/dam boundary 76. A similar collection of bond lines 78 and epoxy dam 80 is shown in this particular embodiment as formed in top surface 18 of substrate 12 at a spaced-apart location. Bond lines 78 and epoxy dam 80 are formed to support the attachment of silicon submount 26 of laser diode source 16. It is to be understood that the specific topology of bond lines 72, 78 is exemplary only; various other arrangements of trenches (e.g., a set of circles or line segments) may be used.

Continuing with the description of processed optical reference surface 18 of common optical reference substrate 12, a separate plurality of bond lines 82 may be formed and used to support optical isolators 34 in position, with a set of bond pads 84 created for attachment of lenses 32. In arrangements where isolators are not used, the position of fiber receiving block 24 may be offset with respect to the defined locations of lenses 32 to reduce the coupling of reflections back into laser devices 22.

The specific set of features used to form bond lines and pads on optical reference substrate 12 is particularly well-suited for use with an optical reference substrate that is formed of silicon. Well-known patterning and etching processes may be used to create the desired shapes at the defined locations, where in one case a deep RIE (DRIE) process may be used. As mentioned above, optical reference substrate 12 may also be formed of a glass (or other material with similar thermal conductivity properties and a CTE match to silicon). For ease of description, the following will refer at times to a "glass substrate", with the understanding that other materials having a low thermal conductivity and CTE match to silicon may also be used.

Since such materials are much less thermally conductive than silicon, the heat generated by the operation of laser diodes 22 may result in performance degradation if laser diode array source 16 were to be directly attached to a glass reference substrate 12G.

In further accordance with the present invention, therefore, an alternative substrate configuration may be used for a glass substrate embodiment so as to accommodate the heat generated by laser diodes 22 and direct this heat away from laser diode array source 16 (in particular), as well as laser engine 10 in general. Reference is made to FIG. 10, which illustrates an exemplary glass-based optical reference substrate 12G particularly formed for this purpose. As shown glass-based optical reference substrate 12G contains the same/similar bond lines and epoxy dam configuration for receiving block 24 of fiber array structure 14 (as well as features 82, 84 for passive optical devise 28). These features may be formed in top reference surface 18G of glass substrate 12G by using a computer-controlled machining process, or a suitable glass-etching or sand blasting process. The bond lines and pads for the passive optical devices are similarly formed. However, in contrast to the configuration as discussed above in association with FIG. 9, glass-based optical reference substrate 12G is formed to include a through-opening 90 which exposes a majority of the underside of silicon submount 26.

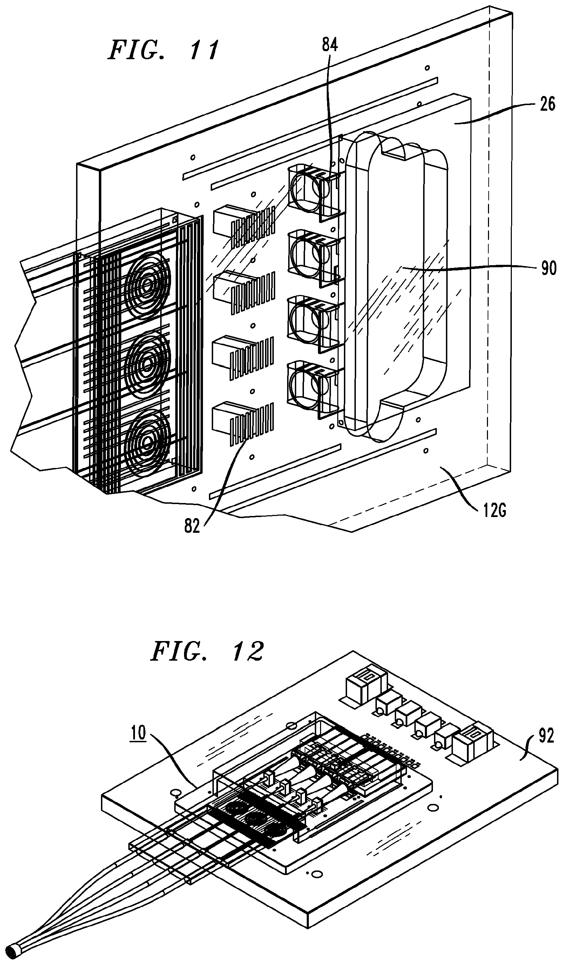

FIG. 11 is a view from underneath substrate 12G, showing the location of silicon submount 26 with respect to through-opening 90. By virtue of including this opening, a separate thermally conductive element may be located in close proximity to silicon submount 26 and create a path for conducting thermal energy away from the operating laser diodes 22. As mentioned above, various other substrate materials may be substituted for glass that exhibit a similar low thermal conductivity and the use of such a through-opening to create a thermal path is useful with these materials as well.

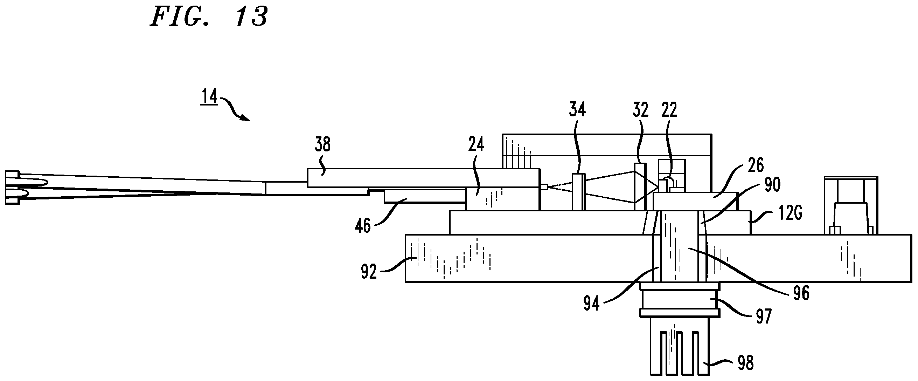

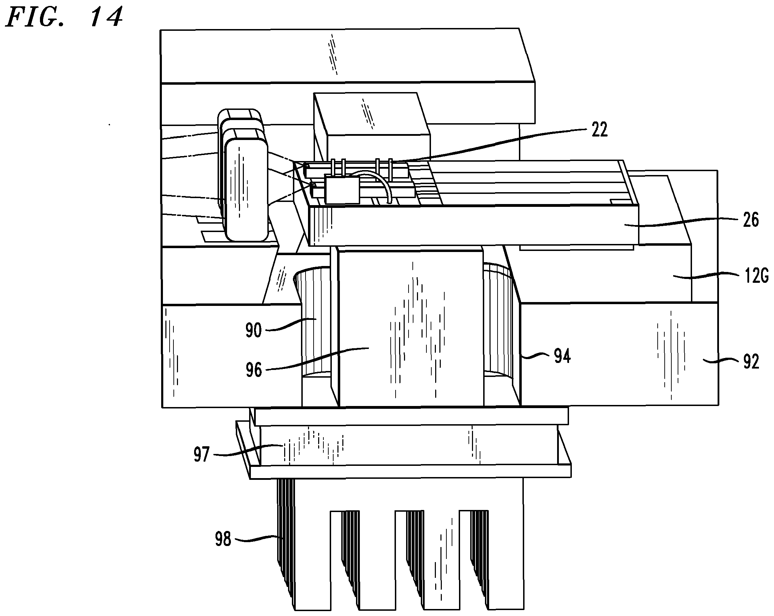

In applications using a low thermal conductivity optical reference substrate (such as substrate 12G discussed above), the final assembly including laser engine 10 may also need to include an arrangement to continue the movement of heat away from laser diodes 22. FIG. 12 is an isometric view of an exemplary assembly where laser engine 10 is mounted on a printed circuit board (PCB) 92. Associated FIGs. 13 and 14 illustrate the modifications also made to PCB 92 to accommodate the use of a low thermal conductivity optical reference substrate 12G, as well as a specific set of devices used to conduct heat away from laser diodes 22.

FIG. 13 is a side view of the assembly, illustrating a through-hole 94 formed in PCB 92 below through-opening 90 formed in optical reference substrate 12G. In this specific embodiment, a set of thermal transport elements includes a high thermal conductivity metal block 96 (for example, a copper slug) disposed in direct physical contact with the underside of silicon submount 26 (as best seen in FIG. 14).

For this specific embodiment of the present invention it is desired to maintain the operating temperature of laser diodes 22 at a temperature that is somewhat less than the ambient temperature. Thus, in addition to removing the heat generated by the operation of the laser diode themselves, the thermal transport elements are used to actually decrease the local ambient temperature at laser diodes 22. The modification and control of laser diodes 22 is provided in this case by a TEC 97 this is disposed adjacent to metal block 96 and oriented so that its "cool" surface 97-C is in contact with metal block 96. The opposing "hot" surface 97-H of TEC 97 is coupled to a heat sink 98 that is used to dissipate the removed heat in a known fashion. The use of a low thermal conductivity optical reference substrate 12G in this embodiment ensures that the reduction of ambient operating temperature provided by TEC 97 to laser diodes 22 is "insulated" from reaching passive optical devices 32, 34, which continue to operate at the nominal ambient temperature. Without providing this type of thermal insulation, the inclusion of a TEC with a laser diode array in this type of laser engine may result in also reducing the ambient temperature of the passive devices, which has been found to result in condensation forming on the optical surfaces (which thus impacts the performance of these devices). While is many embodiments, it is possible and preferred to use a non-hermetic TEC, it is to be understood that in applications where hermeticity needs to be a consideration, the TEC used in combination with laser diodes 22 may be disposed (and sealed) within a housing designed as a hermetic enclosure.

In various embodiments of the present invention, it is desired to further provide covering arrangements for some of the components. For example, a laser enclosure may be positioned on (and bonded to) silicon submount 26, providing a "window" in a sidewall for allowing the generated beams to exit, but otherwise covering and protecting the individual devices.

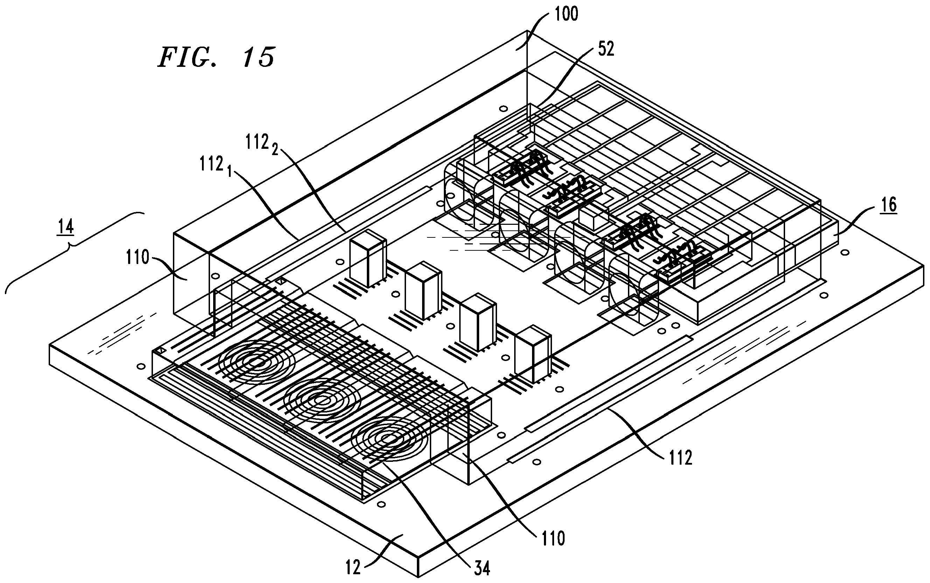

Additionally and as shown in FIG. 15, an outer lid 100 may be attached to common optical reference substrate 12 and used to protect the free-space optical signal paths that exist between laser diodes 22 and their associated optical fibers 20. Lid 100 is shown as including a pair of sidewalls 110, where bottom terminations 110T of each sidewall 110 is disposed over and bonded to top reference surface 18 of common optical reference substrate 12. In particular, FIG. 12 illustrates a pair of channel features 112 formed in top surface 18 and used to bond lid 100 to optical reference substrate 12. These same lid attachment channel features 112 are also evident in, for example, FIGs. 9 and 10.

In the particular embodiment of channel features 112 shown in FIG. 15, each feature includes a pair of parallel epoxy trenches 112₁, 112₂, with sidewall 110 disposed to straddle the pair of trenches 112₁, 112₂. It is to be understood that various other configurations of lid 100 (including its sidewalls 110) and channel features 112 may be used for attachment to optical reference substrate 12 and are considered as falling within the scope of the present invention.

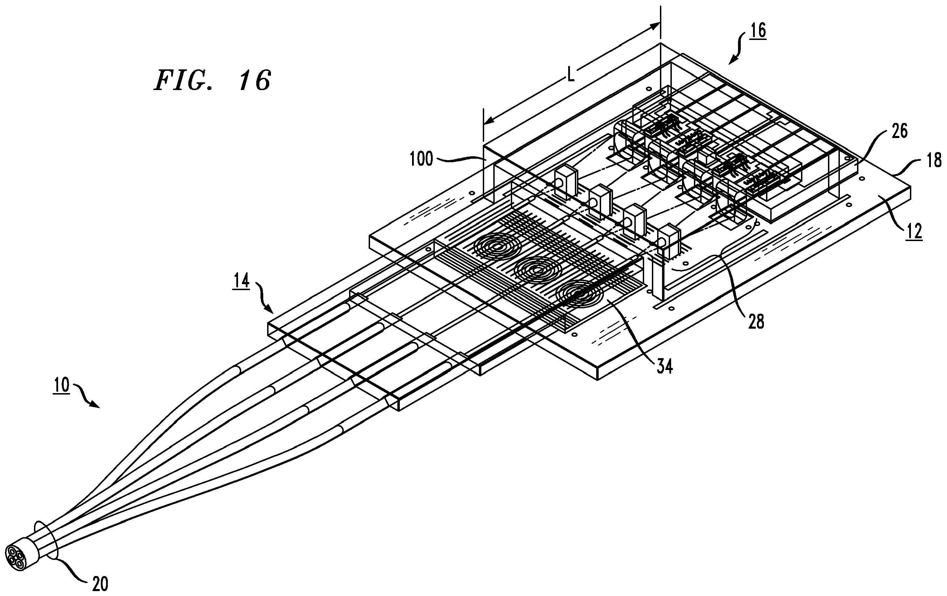

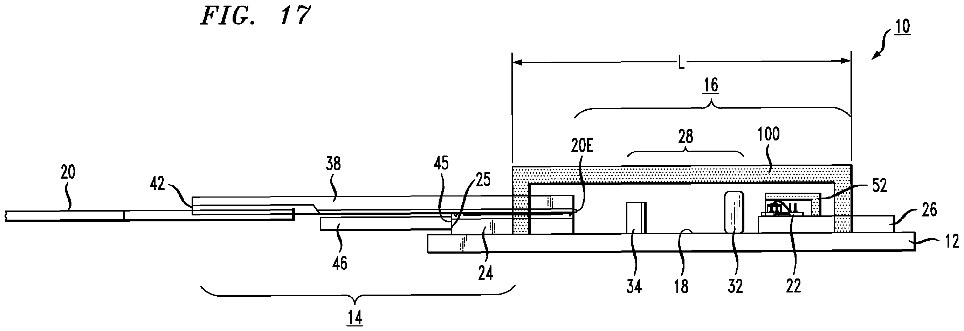

FIG. 16 is an isometric view of completely assembled laser engine 10, with FIG. 17 being a side view of the complete assembly. Evident in these views is the length L of bond lid 100, which is selected to not only protect the free-space optical paths, but also to extend over and encase a portion of fiber array configuration 14 (particularly substrate 38 and receiving block 24). Indeed, it is contemplated that an additional type of sealant, epoxy, or the like may be used to fully secure the complete perimeter.

Although embodiments have been described herein with reference to the accompanying drawings for purposes of illustration, it is to be understood that the present invention is not limited to these specific embodiments, and that various other changes and modifications may be made to various ones of the elements described herein by one skilled in the art without departing from the scope of the invention.

## Claims

1. A laser source assembly comprising
a common optical reference substrate, a top major surface of the common optical reference substrate defining an optical reference plane;
a receiving block attached to the top major surface of the common optical reference substrate at a first defined location, the receiving block including a plurality of V-grooves configured to support a plurality of optical fibers;
a silicon submount attached to the top major surface of the common optical reference substrate at a second defined location, spaced apart from the first defined location, the silicon submount for supporting an array of laser diode sources in optical alignment with the plurality of optical fibers supported by the receiving block in a one-to-one association; and
a plurality of passive optical devices attached to the top major surface of the common optical reference substrate and disposed between the receiving block and the silicon substrate, the plurality of passive optical devices utilized to achieve optical alignment between the plurality of laser diode sources and the plurality of optical fibers.

2. The laser source assembly as defined in claim 1,
wherein the receiving block is configured to exhibit a height H, as measured from the optical reference plane, associated with enabling optical alignment between a core region of a supported optical fiber and an associated laser diode of the array of laser diode sources.

3. The laser source assembly as defined in claim 1,
wherein the assembly further comprises
a fiber array support module, including an array of optical fibers, the fiber array support module including an array of support module V-grooves and alignment features such that the support module V-grooves align with the receiving block V-grooves when the fiber array support module is disposed over and attached to the receiving block.

4. The laser source assembly as defined in claim 3
wherein the fiber array support module further comprises a cover plate, wherein an end wall of the cover plate is positioned to contact an end wall of the receiving block to define a separation between the array of optical fibers and the array of laser diode sources.

5. The laser source assembly as defined in claim 3
wherein the array of optical fibers comprises an array of polarization-maintaining optical fibers.

6. The laser source assembly as defined in claim 1,
wherein the top major surface of the common optical reference substrate is formed to include alignment fiducials and bond lines for positioning and attaching the receiving block at the first defined location and the silicon submount at the second defined location.

7. The laser source assembly as defined in claim 1,
wherein the common optical reference substrate comprises a silicon material.

8. The laser source assembly as defined in claim 7,
wherein the top major surface of the common optical reference substrate is patterned to define locations for alignment fiducials and bond lines, the silicon material etched to define positions for attaching the receiving block at the first defined location and the silicon submount at the second defined location.

9. The laser source assembly as defined in claim 1,
wherein the common optical reference substrate comprises a low thermal conductivity material exhibiting a CTE similar to silicon.

10. The laser source assembly as defined in claim 9
wherein the low thermal conductivity common optical reference substrate further comprises a through-opening at the second defined location, the through-opening providing a path for heat transfer away from the silicon submount.

11. The laser source assembly as defined in claim 10
wherein the assembly further comprises at least one thermal transport element disposed in contact with an underside of silicon submount exposed in the through-opening.

12. The laser source assembly as defined in claim 11
wherein the at least one thermal transport element comprises
a high conductivity metal block disposed in the through-hole and in contact with the silicon submount;
a thermo-electric cooler coupled to the high conductivity metal block, the thermo-electric cooler used to further reduce an ambient temperature of the silicon submount; and
a heat sink disposed over the thermo-electric cooler,
wherein the use of the low thermal conductivity common optical reference substrate provides thermal isolation between the silicon submount and the plurality of passive optical components disposed on the common optical reference substrate.

13. The laser source assembly as defined in claim 1
wherein the assembly further comprising a lid component disposed over an area defining a free space optical path between the array of laser diode devices and the plurality of optical fibers.

14. The laser source as defined in claim 13 wherein the top major surface of the common optical reference substrate is formed to include bond lines defining a location for positioning and attaching sidewalls of the lid component.

15. The laser source as defined in claim 1 wherein the passive optical components comprise a plurality of focusing lenses attached to the top major surface of the common optical substrate at a position adjacent to the silicon submount.

16. The laser source as defined in claim 15 wherein the top major surface of the common optical reference substrate is processed to form a plurality of focusing lens bond pads at locations used in providing optical alignment between the plurality of optical fibers and the plurality of laser diodes.

17. The laser source as defined in claim 15 wherein the passive optical components further comprise a plurality of optical isolators attached to the top major surface of the common optical substrate at a position between the plurality of focusing lenses and the receiving block.

18. The laser source as defined in claim 17 wherein the top major surface of the common optical reference substrate is processed to form a plurality of bond lines at locations defined for placement of the plurality of optical isolators in optical alignment with the plurality of coupling lenses.

## Patentansprüche

1. Eine Laserquellen-Anordnung, aufweisend
ein gemeinsames optisches Referenzsubstrat, wobei eine obere Hauptoberfläche des gemeinsamen optischen Referenzsubstrats eine optische Referenzebene definiert;
einen Aufnahmeblock, der an der oberen Hauptoberfläche des gemeinsamen optischen Referenzsubstrats an einer ersten definierten Stelle angebracht ist, wobei der Aufnahmeblock eine Mehrzahl von V-Nuten aufweist, die so ausgebildet sind, dass sie eine Mehrzahl von optischen Fasern aufnehmen;
einen Silizium-Subträger, der an der oberen Hauptoberfläche des gemeinsamen optischen Referenzsubstrats an einer zweiten definierten Stelle angebracht ist, die von der ersten definierten Stelle beabstandet ist, wobei der Silizium-Subträger zum Tragen eines Arrays von Laserdiodenquellen in optischer Ausrichtung mit der Mehrzahl von optischen Fasern dient, die von dem Aufnahmeblock in einer Eins-zu-Eins-Zuordnung aufgenommen werden; und
eine Mehrzahl passiver optischer Vorrichtungen, die an der oberen Hauptoberfläche des gemeinsamen optischen Referenzsubstrats angebracht und zwischen dem Empfangsblock und dem Siliziumsubstrat angeordnet sind, wobei die Mehrzahl passiver optischer Vorrichtungen verwendet wird, um eine optische Ausrichtung zwischen der Mehrzahl von Laserdiodenquellen und der Mehrzahl von optischen Fasern zu erreichen.

2. Die Laserquellen-Anordnung nach Anspruch 1, wobei der Empfangsblock so ausgebildet ist, dass er eine Höhe H, gemessen von der optischen Referenzebene, aufweist, die mit der Ermöglichung der optischen Ausrichtung zwischen einem Kernbereich einer gehaltenen optischen Faser und einer zugehörigen Laserdiode des Arrays von Laserdiodenquellen verbunden ist.

3. Die Laserquellen-Anordnung nach Anspruch 1, wobei die Anordnung weiterhin aufweist
ein Faserarray-Haltemittelmodul, das ein Array optischer Fasern enthält, wobei das Faserarray-Haltemittelmodul ein Array von V-Nuten des Haltemittels und Ausrichtungselemente enthält, so dass die V-Nuten des Haltemittels mit den V-Nuten des Empfangsblocks miteinander fluchten, wenn das Faserarray-Haltemittelmodul über dem Empfangsblock angeordnet und an diesem befestigt ist.

4. Die Laserquellen-Anordnung nach Anspruch 3 definiert, wobei das Haltemittel für das Faserarray ferner eine Abdeckplatte aufweist, wobei eine Endwand der Abdeckplatte so positioniert ist, dass sie eine Endwand des Aufnahmeblocks berührt, um eine Trennung zwischen dem Array von optischen Fasern und dem Array von Laserdiodenquellen zu bilden.

5. Die Laserquellen-Anordnung nach Anspruch 3, wobei das Array von optischen Fasern ein Array von polarisationserhaltenden optischen Fasern aufweist.

6. Die Laserquellen-Anordnung nach Anspruch 1, wobei die obere Hauptoberfläche des gemeinsamen optischen Referenzsubstrats so ausgebildet ist, dass sie Ausrichtungs-Referenzpunkte und Verbindungslinien zum Positionieren und Befestigen des Empfangsblocks an der ersten definierten Stelle und des Silizium-Submounts an der zweiten definierten Stelle enthält.

7. Die Laserquellen-Anordnung nach Anspruch 1, wobei das gemeinsame optische Referenzsubstrat ein Siliziummaterial aufweist.

8. Die Laserquellen-Anordnung nach Anspruch 7, wobei die obere Hauptoberfläche des gemeinsamen optischen Referenzsubstrats strukturiert ist, um Positionen für Ausrichtungs-Referenzpunkte und Verbindungslinien zu bilden, wobei das Siliziummaterial geätzt ist, um Positionen zum Befestigen des Empfangsblocks an der ersten definierten Stelle und des Silizium-Submounts an der zweiten definierten Stelle zu definieren.

9. Die Laserquellen-Anordnung nach Anspruch 1, wobei das gemeinsame optische Referenzsubstrat ein Material mit geringer Wärmeleitfähigkeit aufweist, das einen WAK ähnlich dem von Silizium aufweist.

10. Die Laserquellen-Anordnung nach Anspruch 9, wobei das gemeinsame optische Referenzsubstrat mit geringer Wärmeleitfähigkeit ferner eine Durchgangsöffnung an der zweiten definierten Stelle aufweist, wobei die Durchgangsöffnung einen Pfad für die Wärmeübertragung weg von dem Silizium-Submount bildet.

11. Die Laserquellen-Anordnung nach Anspruch 10, wobei die Anordnung ferner mindestens ein Wärmetransportelement aufweist, das in Kontakt mit einer Unterseite des Silizium-Subträgers angeordnet ist, der in der Durchgangsöffnung freiliegt.

12. Die Laserquellen-Anordnung nach Anspruch 11, wobei das mindestens eine thermische Transportelement Folgendes aufweist
einen Metallblock mit hoher Leitfähigkeit, der in der Durchgangsöffnung angeordnet ist und in Kontakt mit dem Silizium-Submount steht;
einen thermoelektrischen Kühler, der mit dem Metallblock mit hoher Leitfähigkeit gekoppelt ist, wobei der thermoelektrische Kühler verwendet wird, um eine Umgebungstemperatur des Siliziumunterträgers weiter zu reduzieren; und
eine Wärmesenke, die über dem thermoelektrischen Kühler angeordnet ist, wobei die Verwendung des gemeinsamen optischen Referenzsubstrats mit niedriger Wärmeleitfähigkeit eine thermische Isolierung zwischen dem Silizium-Submount und der Mehrzahl der passiven optischen Komponenten, die auf dem gemeinsamen optischen Referenzsubstrat angeordnet sind, bereitstellt.

13. Die Laserquellen-Anordnung nach Anspruch 1, wobei die Anordnung ferner eine Deckelkomponente aufweist, die über einem Bereich angeordnet ist, der einen optischen Freiraum-Pfad zwischen dem Array von Laserdioden-Vorrichtungen und der Mehrzahl von optischen Fasern definiert.

14. Die Laserquelle nach Anspruch 13, wobei die obere Hauptoberfläche des gemeinsamen optischen Referenzsubstrats so ausgebildet ist, dass sie Verbindungslinien enthält, die eine Stelle zum Positionieren und Befestigen von Seitenwänden der Deckelkomponente definieren.

15. Die Laserquelle nach Anspruch 1, wobei die passiven optischen Komponenten eine Mehrzahl von Fokussierlinsen aufweisen, die an der oberen Hauptoberfläche des gemeinsamen optischen Substrats an einer Position neben dem Silizium-Submount angebracht sind.

16. Die Laserquelle nach Anspruch 15, wobei die obere Hauptoberfläche des gemeinsamen optischen Referenzsubstrats bearbeitet wird, um eine Mehrzahl von Fokussierlinsen-Bondpads an Stellen auszubilden, die beim Schaffen einer optischen Ausrichtung zwischen der Mehrzahl von optischen Fasern und der Mehrzahl von Laserdioden verwendet werden.

17. Die Laserquelle nach Anspruch 15, wobei die passiven optischen Komponenten weiterhin eine Mehrzahl von optischen Isolatoren aufweisen, die an der oberen Hauptoberfläche des gemeinsamen optischen Substrats an einer Position zwischen der Mehrzahl von Fokussierlinsen und dem Empfangsblock angebracht sind.

18. Die Laserquelle nach Anspruch 17, wobei die obere Hauptoberfläche des gemeinsamen optischen Referenzsubstrats bearbeitet wird, um eine Mehrzahl von Verbindungslinien an Stellen auszubilden, die zur Platzierung der Mehrzahl von optischen Isolatoren in optischer Ausrichtung mit der Mehrzahl von Koppellinsen definiert sind.

## Revendications

1. Un ensemble de source laser qui comprend
un substrat de référence optique commun, une surface principale supérieure du substrat de référence optique commun définissant un plan de référence optique;
un bloc de réception fixé à la surface principale supérieure du substrat de référence optique commun à un premier emplacement tel que défini, le bloc de réception comprenant une pluralité de rainures en V configurées pour supporter une pluralité de fibres optiques ;
un sous-montage en silicium fixé à la surface principale supérieure du substrat de référence optique commun à un deuxième emplacement défini, à distance du premier emplacement défini, le sous-montage en silicium supportant un réseau de sources de diodes laser en alignement optique avec la pluralité de fibres optiques supportées par le bloc de réception dans une association biunivoque ; et
une pluralité de dispositifs optiques passifs fixé à la surface principale supérieure du substrat de référence optique commun et disposé entre le bloc de réception et le substrat de silicium, la pluralité de dispositifs optiques passifs utilisé pour réaliser l'alignement optique entre la pluralité de sources de diodes laser et la pluralité de fibres optiques.

2. L'ensemble de source laser tel que défini à la revendication 1, dans lequel le bloc de réception est configuré pour présenter une hauteur H, mesurée à partir du plan de référence optique, associée à la réalisation de l'alignement optique entre une région centrale d'une fibre optique supportée et une diode laser associée du réseau de sources de diodes laser.

3. L'ensemble de sources laser tel que défini à la revendication 1, dans lequel l'ensemble comprend en outre
un module de support de réseau de fibres, comprenant un réseau de fibres optiques, le module de support de réseau de fibres comprenant un réseau de rainures en V du module de support et des moyen d'alignement telles que les rainures en V du module de support s'alignent sur les rainures en V du bloc de réception lorsque le module de support de réseau de fibres est disposé sur le bloc de réception et fixé à celui-ci.

4. L'ensemble de source laser tel que défini à la revendication 3, dans lequel le module de support de réseau de fibres comprend en outre une plaque de recouvrement, dans laquelle une paroi terminale de la plaque de recouvrement est positionnée pour entrer en contact avec une paroi terminale du bloc de réception afin de définir une séparation entre le réseau de fibres optiques et le réseau de sources de diodes laser.

5. L'ensemble de source laser tel que défini à la revendication 3, dans lequel le réseau de fibres optiques comprend un réseau de fibres optiques à maintien de polarisation.

6. L'ensemble de source laser tel que défini à la revendication 1, dans lequel la surface principale supérieure du substrat de référence optique commun est formée pour inclure des repères d'alignement et des lignes de liaison pour positionner et fixer le bloc de réception au premier emplacement défini et le sous-montage en silicium au deuxième emplacement défini.

7. L'ensemble de source laser tel que défini à la revendication 1, dans lequel le substrat de référence optique commun comprend un matériau en silicium.

8. L'ensemble de source laser tel que défini à la revendication 7, dans lequel la surface principale supérieure du substrat de référence optique commun est modelée pour définir les emplacements des repères d'alignement et des lignes de liaison, le matériau de silicium étant gravé pour définir les positions de fixation du bloc de réception au premier emplacement défini et du sous-montage en silicium au deuxième emplacement défini.

9. L'ensemble de source laser tel que défini à la revendication 1, dans lequel le substrat de référence optique commun comprend un matériau à faible conductivité thermique présentant un CDT similaire au silicium.

10. L'ensemble de source laser tel que défini à la revendication 9, dans lequel le substrat de référence optique commun à faible conductivité thermique comprend en outre une ouverture traversante au deuxième emplacement défini, l'ouverture traversante fournissant un passage pour le transfert de chaleur loin du sous-montage en silicium.

11. L'ensemble de source laser tel que défini à la revendication 10, dans lequel l'ensemble comprend en outre au moins un élément de transport thermique disposé en contact avec une face inférieure du sous-montage en silicium ouvert dans l'ouverture traversante.

12. L'ensemble de source laser tel que défini à la revendication 11, dans lequel l'au moins un élément de transport thermique comprend
un bloc métallique à haute conductivité disposé dans le trou traversant et en contact avec le sous-montage en silicium ;
un refroidisseur thermoélectrique couplé au bloc métallique à haute conductivité, le refroidisseur thermoélectrique étant utilisé pour réduire davantage la température ambiante du sous-montage en silicium ; et
un dissipateur thermique disposé sur le refroidisseur thermoélectrique, dans lequel l'utilisation du substrat de référence optique commun à faible conductivité thermique fournit une isolation thermique entre le sous-montage en silicium et la pluralité de dispositifs optiques passifs disposés sur le substrat de référence optique commun.

13. L'ensemble de source laser tel que défini à la revendication 1, dans lequel l'ensemble comprend en outre un composant de couvercle disposé sur une zone définissant un passage optique en espace libre entre le réseau d'appareils à diode laser et la pluralité de fibres optiques.

14. La source laser telle que définie à la revendication 13, dans laquelle la surface principale supérieure du substrat de référence optique commun est formée pour inclure des lignes de liaison définissant un emplacement pour le positionnement et la fixation des parois latérales du composant du couvercle.

15. La source laser telle que définie à la revendication 1, dans laquelle les composants optiques passifs comprennent une pluralité de lentilles de focalisation fixées à la surface majeure supérieure du substrat optique commun à une position adjacente au sous-montage en silicium.

16. La source laser telle que définie à la revendication 15, dans laquelle la surface majeure supérieure du substrat de référence optique commun de référence est traitée pour former une pluralité de plots de collage de lentilles de focalisation à des emplacements utilisés pour fournir un alignement optique entre la pluralité de fibres optiques et la pluralité de diodes laser.

17. La source laser telle que définie à la revendication 15, dans laquelle les composants optiques passifs comprennent en outre une pluralité d'isolateurs optiques fixés à la surface majeure supérieure du substrat optique commun à une position située entre la pluralité de lentilles de focalisation et le bloc de réception.

18. La source laser telle que définie à la revendication 17, dans laquelle la surface majeure supérieure du substrat de référence optique commun de référence est traitée pour former une pluralité de lignes de liaison à des emplacements définis pour le placement de la pluralité d'isolateurs optiques dans l'alignement optique avec la pluralité de lentilles de couplage.
